# EUROPEAN PATENT SPECIFICATION

(11) **EP 0 447 449 B1**
(45) Date of publication and mention of the grant of the patent: **02.11.1994**
(21) Application number: 90900588.6
(22) Date of filing: 11.12.1989
(51) Int. Cl.: G01D 5/20, G01R 27/26, H03K 17/95

(54) **MEANS AND METHOD FOR MEASURING INDUCTANCE**
MITTEL UND VERFAHREN ZUM MESSEN DER INDUKTANZ
PROCEDE ET APPAREIL PERMETTANT DE MESURER L'INDUCTANCE

(30) Priority: 12.12.1988 US 282611
(43) Date of publication of application: 25.09.1991
(73) Proprietor: CURTIS INSTRUMENTS, INC., Mount Kisco, NY 10549-1407 (US)
(72) Inventor: FINGER, Eugene, P., Brewster, NY 10509 (US); JALBERT, Bernard, W., Richboro, PA 18954 (US); PENKALSKI, Thomas, A., Broad View Heights, OH 44147 (US)
(74) Representative: Blatchford, William Michael
(86) International application number: US8905626
(87) International publication number: WO9007126

(56) References cited:
- EP-A- 0 126 846
- DE-A- 2 852 637
- FR-A- 2 585 824
- GB-A- 2 040 054
- US-A- 4 130 183
- US-A- 4 647 892
- US-A- 4 649 341
- US-A- 4 701 676
- MACHINE DESIGN, vol. 60, no. 11, 19 May 1988, Cleveland, US, pages 149-173; "Sensors and Transducers"

## Description

This invention relates to the measurement of inductance generally and, more particularly, to an electronically calibratable proximity, or inductive, switch having a high degree of sensitivity while at the same time being economically manufactured and suitable for use in harsh environments.

While the present invention has numerous applications, it is especially well suited for use on mobile equipment such as fork lift trucks, manufactured, for example, by Yale Materials Handling Corporation, that may be used in industrial and other environments where the switches may be subjected to mechanical abuse, low and high temperatures, and dirty and abrasive atmospheres.

Typically, such trucks employ a number of mechanical "microswitches" which are activated by the movement of a mechanical part on the truck against a movable arm on the microswitch. The movement of the arm, in turn, effects the closing (or opening) of electrical contacts within the switch, thus providing an indicator signal that the switch has been closed or opened or a control signal as an input to some other device.

Some points of use for microswitches in fork lift trucks are those in connection with the hydraulic control system, platform switches, and brake switches. These microswitches have been found to be troublesome, due to the tolerances in the linkage which activates the switch, the mounting configuration of the switch, the fastening of the wires to the switch, the fact that the switch has contacting and moving parts, and the mechanical tolerances of the inner workings of the switch itself. Further, because a mechanical switch is an easily understood and relatively easily replaced device, it is susceptible to being blamed for most failures, which delays the eventual repair or replacement of the truly defective part.

Proximity switches are known which comprise LRC resonant circuits. When there is no metal near the inductor of the circuit, the circuit gives a high output. When metal comes within a selected distance of the inductor, the metal and the inductor become inductively coupled, the circuit is detuned, and the output of the circuit drops. Another type of known proximity switch is the magnetic switch, such as the reed switch, which is open or closed depending upon its proximity to a magnet. While these known devices are satisfactory in many applications they have a number of disadvantages. The reed switches are generally unsatisfactory in harsh environments, as sharp movements or vibrations can open or close the switches. Resonant circuits require tuning of a capacitance and an inductor and, when a given such switch is installed in a particular piece of equipment, metals other than the actuator may affect performance. Resonant circuits are also prone to electrical noise problems and are sensitive to variations in frequency and voltage. Both types require fairly careful mechanical adjustment and neither can provide multilevel position sensing. Both are relatively expensive and neither can be electronically recalibrated once installed.

US-A-4,649,341 (Ulrich et al) discloses an arrangement in which the position of a movable inductor core is determined by applying a voltage pulse across an inductor coil. The coil is connected to a measuring circuit which includes a capacitor and a microprocessor. at the end of the pulse, the coil is disconnected from the measuring circuit and the capacitor is thereafter discharged through a resistor. The time for the capacitor to discharge to a predetermined voltage level is determined by the microprocessor and is used as a measurement of the inductance of the inductor.

GB-A-2040054 (Eldec Corp.) relates to a proximity switch in which the proximity of an object to an inductor is determined by applying a current pulse to an RC sensor unit and measuring the voltage across the unit. When the voltage reaches a predetermined reference level, the voltage is clamped at this level and the rate of change of the sensor unit current is measured when the current level goes through zero so as to derive the inductance of the inductor.

In DE-A-2852637 there is described an arrangement in which a comparator has an input coupled to the junction of a series connected inductor and resistor. A train of square wave pulses is applied to the inductor and if the voltage input to the comparator drops below a set level before the end of a given pulse, the time interval between that occurrence and the end of the pulse is determined to derive an inductance value.

US-A-4,701,676 uses inductors in an impedance network which is connected to a lamp. When the lamp is touched, the resonant frequency of the combination of the impedance network and the lamp changes and the circuitry connected to it turns the lamp on.

It is an object of the present invention to provide an inductive switch which is electronically calibratable after installation.

According to a first aspect of the invention, there is provided an inductive switch comprising: inductor means; actuator means movable with respect to the inductor means, the movement affecting the inductance of the inductor means; and means to apply an electrical pulse of a selected duration to the inductor means; and characterised in that the switch further comprises means to measure the level of current directly from the inductor means a selected time interval after the initiation of the said pulse and to provide a switching signal output when the said level of current is above a predetermined value.

The means to measure preferably remains directly connected to the inductor means until the level of current is measured. Measurement may be performed by means of a sense resistor connected to the inductor means and circuitry coupled to the sense resistor to compare the voltage across the sense resistor at the end of the predetermined interval with a reference voltage. Thus, when a selected value of the current is reached, the switch is triggered. A plurality of inductors may be sequentially interrogated by one electronic circuit, thus requiring low power and affording smooth operation. Calibration of the trigger point is accomplished electronically after mechanical installation, thus inherently compensating for mechanical tolerances and proximity effects.

The actuator means may be an actuator rod connected to a control handle, brake treadle or platform treadle of a fork lift truck, movement of such handle or treadle causing the actuator rod to advance into or withdraw from a bore defined in the inductor means, thereby causing a change in the inductance of the inductor means.

In its preferred form the invention provides an inductive switch which is rugged and may be used in harsh environments with wide temperature variations. The preferred switch is highly accurate, yet is economical to manufacture, is easily installed, and requires little maintenance. In its preferred form the present invention provides an inductive switch such that when a plurality of switches are used in an application, the condition of all such switches may be determined sequentially and rapidly by a single electronic circuit. The preferred inductive switch may be readily mounted in place of a microswitch.

The invention also includes a method of measuring the inductance of an inductor including applying an electrical pulse of a selected duration to the inductor the method being, characterised by measuring the level of current directly from the inductor a selected time interval after the initiation of the electrical pulse, said current being proportional to the value of inductance of the inductor.

The invention will now be described by way of example with reference to the drawings in which:-
Figures 1A and 1B comprise an electrical schematic diagram of an inductive switch system constructed in accordance with the present invention;
Figure 1C illustrates the arrangement of the sheets containing Figures 1A and 1B when joined;
Figure 2 is a cross-sectional view of an inductive element for use in the system of Figure 1;
Figure 3 is a partial rear elevation view of a fork lift truck employing an inductive switch in accordance with the invention;
Figures 4 and 5 are partial side elevation views of a fork lift truck employing an inductive switch in accordance with the invention;
Figures 6 and 7 are partial rear elevation views of a fork lift truck employing an inductive switch in accordance with the invention; and
Figure 8 is an electrical schematic diagram of a portion of an alternative inductive switch system in accordance with the invention.

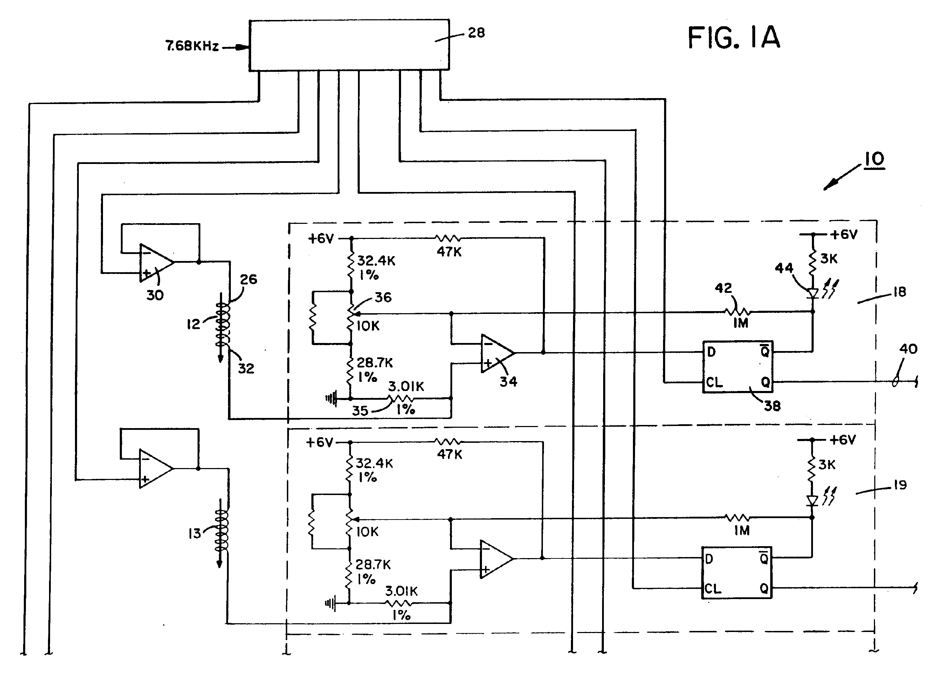

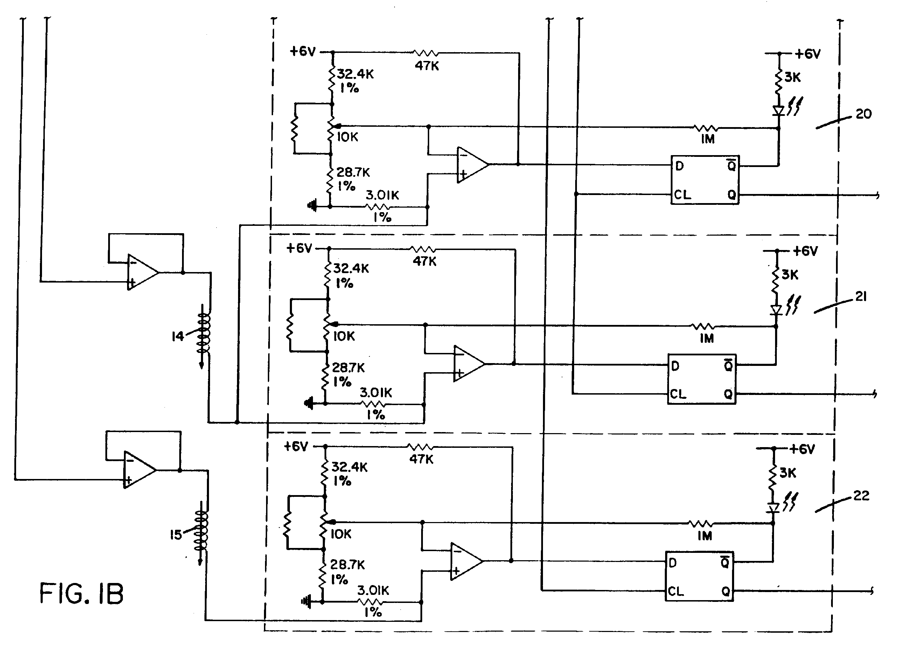

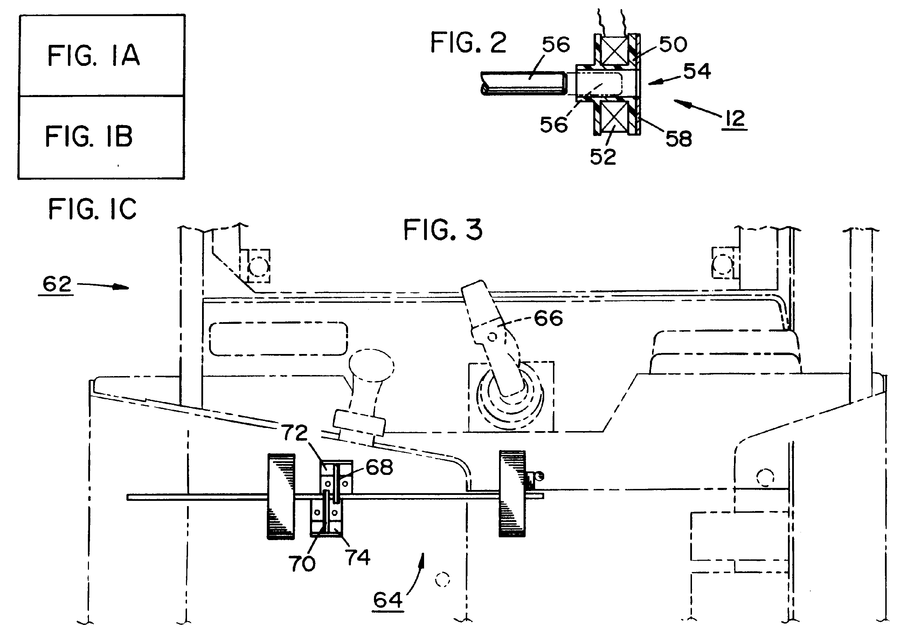

Referring now to the drawings, Figures 1A and 1B illustrate an inductive switch system generally indicated by the reference numeral 10, which includes inductors 12, 13, 14 and 15, an example of which inductors is inductor 12 shown in cross-section on Figure 2. Associated with each of inductors 12, 13, and 15 are, respectively, position detection circuits 18, 19, and 22. Associated with inductor 14 are position detection circuits 20 and 21, the function of these two position detection circuits being described in detail later.

The construction and operation of an inductor and its associated position detection circuit will be described with reference to inductor 12 and position detection circuit 18 only, as it can be seen that the other inductors and position detection circuits are constructed identically to the former with the exception of inductor 14 which has two associated position detection circuits.

Inductor 12 is connected as shown to receive, at first end 26, an electrical pulse from a divide-by-ten ring counter 28 which receives as an input a 7.68 KHz. clock. A unity-gain operational amplifier 30 is connected between divide-by-ten ring counter 28 and inductor 12 and acts as a buffer to provide isolation. Second end 32 of inductor 12 is connected to position detection circuit 18 to provide an input to comparator 34 and is also connected to ground through a sense resistor 35. The reference voltage to comparator 34 is determined by a potentiometer 36 and its associated resistor network. The output of comparator 34 provides data input to data flip-flop 38. Data flip-flop 38 is connected to be strobed by divide-by-ten ring counter 28 and to provide an output on a lead 40, which output may be connected to other, conventional circuitry for indication or control functions. Data flip-flop 38 also provides an inverted output to the reference side of comparator 34 through feedback resistor 42. An LED 44 may be provided at the inverted output of data flip-flop 38 to indicate the position of the switch.

Referring now to Figure 2, inductor 12 includes a channel-shaped bobbin 50 on which is wound a coil 52. Formed in bobbin 50, centrally of inductor 12, is a bore 54. Bobbin 50 is disposed such that bore 54 is axially aligned with actuator rod 56 which is movable from the position shown in solid lines to the position shown in dashed lines where it extends partially into a portion of the bore around which coil 52 is wound. Actuator rod 56 also may extend through inductor 12 so that it protrudes (not shown) from the side of bobbin 50 opposite the side where it entered. Inductor 12 may also include a concentrator 58 adjacent a wall of bobbin 50. Actuator rod 56 may be assumed to be operatively connected, for example, to a moving part of a machine (not shown), where it is desired that a selected position of said part will cause a change in the output signal on lead 40 (Figure 1).

For purposes of the discussion herein, and in accordance with standard practice when dealing with equipment such as fork lift trucks, the "iron in" condition, that is, when actuator rod 56 (Figure 2) is inserted into inductor 12 to, or past, its "trigger point", is the inactive, or "off", condition. Conversely, the "iron out" condition, that is, when actuator rod 56 is withdrawn from inductor 12 away from the trigger point, is the active, or "on" condition. This is the preferable arrangement, since it is inherently fail safe, as a broken wire in the system circuitry or a short circuit in the driver circuitry appears to the position detection circuit as infinite inductance. Consequently, the operation being controlled by the switch will remain in its off position when such failure occurs.

For a description of the operation of the inductive switch, it will be assumed that actuator rod 56 is in its solid-line, or iron out, position shown on Figure 2 or otherwise does not extend into inductor 12 to its trigger point, but is moving toward its dashedline, or iron in, position which will be assumed to be at or past the trigger point. Divide-by-ten ring counter 28 provides a relatively short first step pulse of current at a potential of about 5 volts to inductor 12 through operational amplifier 30. The inductance of inductor 12 is then at a relatively low level thus allowing a relatively high flow of current through the inductor and presenting a relatively high voltage input to comparator 34, which voltage is the voltage across sense resistor 35. Since this voltage will be above the reference voltage to comparator 34 of on the order of 2.5 volts plus or minus a voltage increment introduced by feedback resistor 42, the output of the comparator, and, therefore, the data input to data flip-flop 38 will be high, which, when the data flip-flop is subsequently strobed by divide-by-ten ring counter 28, provides a high output on lead 40 and a low output to feedback resistor 42. The latter output allows LED 44 to energize. At a selected interval of time after the initiation of the first step pulse, preferably at the end of the first pulse, a second step pulse is generated which is applied to inductor 13 and, simultaneously, the second step pulse strobes data flip-flop 38 which, there being no change in condition, initiates no change in the state of the data flip-flop which outputs a high signal on lead 40 and a low signal to feedback resistor 42.

This sequence continues, with a third generated pulse being applied to inductor 14 and simultaneously strobing the data flip-flop in position detection circuit 19, etc. Thus, pulses are sequentially applied to each inductor in switch 10, with each pulse simultaneously strobing the data flip-flop associated with the inductor to which the preceding pulse was applied.

The interrogation pulses are preferably applied at the end of the current build up pulses, but the interrogation pulses may be applied somewhat before or somewhat after the end of the current build up pulses. The sequential energization and strobing provides for a low and even demand on the power supply and allows for smoother operation of the system, although there is no requirement in practicing the present invention that a succeeding pulse be used to interrogate a data flip-flop or that the sequential steps described for illustrative purposes be employed.

Assume, now, that inductor 12 has received a number of pulses without change in the output of data flip-flop 38; but, that before that inductor receives its next pulse, actuator rod 56 has reached the trigger point, or "iron in" condition in the inductor. Now, with this pulse, the inductance in coil 52 will be relatively high, the current from the coil will be relatively low as will the level of voltage input to comparator 34 which will give a low input to data flip-flop 38. Then, when data flip-flop is strobed by the next succeeding pulse to inductor 13, the state of the flip-flop will switch and a low signal will appear on lead 40 and a high level will be applied to feedback resistor 42 and LED 44, thus extinguishing the LED. Feedback resistor 42 adds a slight increment to the reference voltage to comparator 34, thus introducing a small amount of hysteresis into the circuit to prevent electronic chattering or oscillation.

As actuator rod 56 is withdrawn from bore 54, the trigger point will again be reached, comparator 34 will have a high output, and, when data flip-flop 38 is subsequently strobed, its outputs will return to their original values, LED 44 will energize, and feedback resistor 42 will subtract a small increment from the reference voltage.

As noted above, inductor 14 has two associated position detection circuits 20 and 21 connected in parallel with the output of the inductor. This arrangement illustrates one particular advantage - that of being able to provide two trigger points with a single actuator. This is accomplished by adjusting the potentiometers in position detection circuits 20 and 21 so that each will respond to a different degree of insertion of an actuator rod into inductor 14, thus allowing two control functions with the same inductor element. In order to give greater differentiation between the two trigger points, one can give the actuator rod a variable shape longitudinally, such as by having a step in the diameter of the rod. It may also be advantageous in some applications to use a rod having sections of both ferromagnetic and paramagnetic materials such as soft iron and aluminum. Of course, the number of trigger points with a single inductor is not limited to two. It is also not necessary that the actuator rod have a round cross-section, but it is preferable that the rod have the same cross-sectional shape as the bore of the inductor. An important feature of the present invention is that the selection, or not, of multiple trigger points may be accomplished electronically after the inductor has been installed and requires no mechanical adjustments.

In some retrofit applications, the use of a compound actuator rod may be especially advantageous. One such application is where an existing ferromagnetic element which one desires to use as an actuator rod is attached to other elements at each end. Therefore, when an inductor is placed around the actuator rod, an "iron out" condition cannot be achieved and the inductor will have relatively constant high inductance regardless of the position of the rod. Here, the solution is to place a thin copper sleeve over a portion of the rod to shield that portion from the inductor. The copper sleeve is so positioned that, when that portion of the rod on which the sleeve is mounted is inserted into the inductor, the inductance will be low and an "iron out" condition will be achieved and, when that portion of the rod on which the sleeve is mounted is withdrawn from the inductor, the inductance will be high and an "iron in" condition will be achieved. Although the copper sleeve does not shield the rod to the extent that the inductor "sees" perfect air, the difference is enough that satisfactory performance may be realized. The copper sleeve is preferably adhesively attached to the rod.

A particular advantage of the described switch is that there are no components that require tuning, such as with LRC circuits, and the switch can be electronically calibrated after installation in the field. For example, within reasonable limits, the inductor element may be installed in a piece of machinery without regard to exact tolerances or special concern for the proximity of ferromagnetic materials unrelated to the switch. Then, whatever (usually a rod) the motion of which is to actuate the switch is moved to the desired trigger point and the potentiometer in the position detection circuit is adjusted to give the exact "trigger point". Such means of calibration compensates for inaccuracies in the physical mounting of the inductor element and its associated actuator rod as well as any lash of the rod, metal parts in proximity to the inductor element, and even variations in the construction of the inductor element itself.

For the inductive switch system described, a pulse interval of on the order of about 130 microseconds has been found to be satisfactory, although pulse intervals may range from about 10 microseconds to about 1 millisecond. Because of the shortness of the pulse, a large number of switches can be interrogated sequentially. The lower end of the range of pulse lengths is limited by what practical electronics can handle, while the upper end of the range becomes limited by the higher inductances required. The width of the interrogation pulse can be conveniently selected to be the same time interval as the energizing pulse, although it may also be selected to be less. When selecting component values and impulse times, it must be kept in mind that the inductor should preferably discharge to a zero level, or essentially a zero level, before the succeeding pulse is applied. It is also desirable that the inductance-versus-actuator rod position curve be fairly linear and steep in the area of the trigger point. Use of an inductor as a constant current generator provides smoothing and keeps the system noise free.

For the values of the components shown on Figure 1, an inductor coil having about 4680 turns of #39 AWG copper wire (approximately 223 metres (8760 inches)) wound with an inner diameter of about 9.8 mm (0.385 inch) and a length of about 9.1 mm (0.360 inch) gives satisfactory performance. Such a coil exhibits an inductance of about 218 milliHenrys and a resistance of about 622 Ohms at 25 degrees Centigrade. It has been found that the inductive switch system described is accurate and repeatable to at least a few thousandths of an inch and is inherently temperature independent over a fairly large range; however, if some application exhibit an intolerable position-versus-inductance temperature coefficient, temperature compensation may be provided within the coil structure or within the electronic circuitry by means known in the art.

It has been found that the use of a concentrator extends the length of the transfer function of the inductor without requiring the use of a longer coil. A similar lengthening may be obtained by using multiple stacked coils and/or permitting the actuator rod to extend through the bore of the inductor. This lengthening effect can be of particular value when, for example, the inductor of the present invention is being substituted for, say, a microswitch in an existing application.

The material of the actuator rod of an inductor is preferably soft iron and the concentrator is preferably formed from cold-rolled steel, although the system is quite tolerant of alloy variations. For a coil having on the order of the above dimensions, the concentrator should be at least on the order of 0.06-inch thick and extend to the outer perimeter of the coil of the inductor. The concentrator element may also be a bracket on which the inductor is mounted. It has been found that when the perimeter of the concentrator extends to the outer perimeter of the coil, it has essentially the same effect as a steel plate of infinite area. Thus, standardizing the material immediately adjacent the inductor by having the outer dimensions of the concentrator at least coextensive with the coil reduces proximity effects by making them uniform and thereby enhances ease of installation because the user will obtain uniform performance regardless of whether the inductor is mounted on metal of a greater or lesser area.

The bobbin may be constructed of any suitable dielectric material and glass-filled nylon has been found to be especially satisfactory.

It can be seen that all components of the inductive switch system are conventional and, in effect, the system uses imprecise parts to make a very precise device. As noted above, the actuator rod may be that already existing in a retrofit situation and the inductor used may even be that formerly used in an RLC switch, so that no mechanical changes at all may be required - it only being necessary to connect the electronics of the system. Since the current from the inductor is being measured resistively, there are no components in the system which require tuning. The inductive switch system, having but one moving part - the actuator rod - and no exposed contacts is very rugged and environmentally secure and, if necessary, the electronics can be located well away from areas that might be detrimental to them.

Figures 3-7 illustrate the application of the system to various functions in a fork lift truck, generally indicated by the reference numeral 62. In each case, it may be assumed that the inductor has replaced a microswitch or other switching element having the undesirable features discussed above.

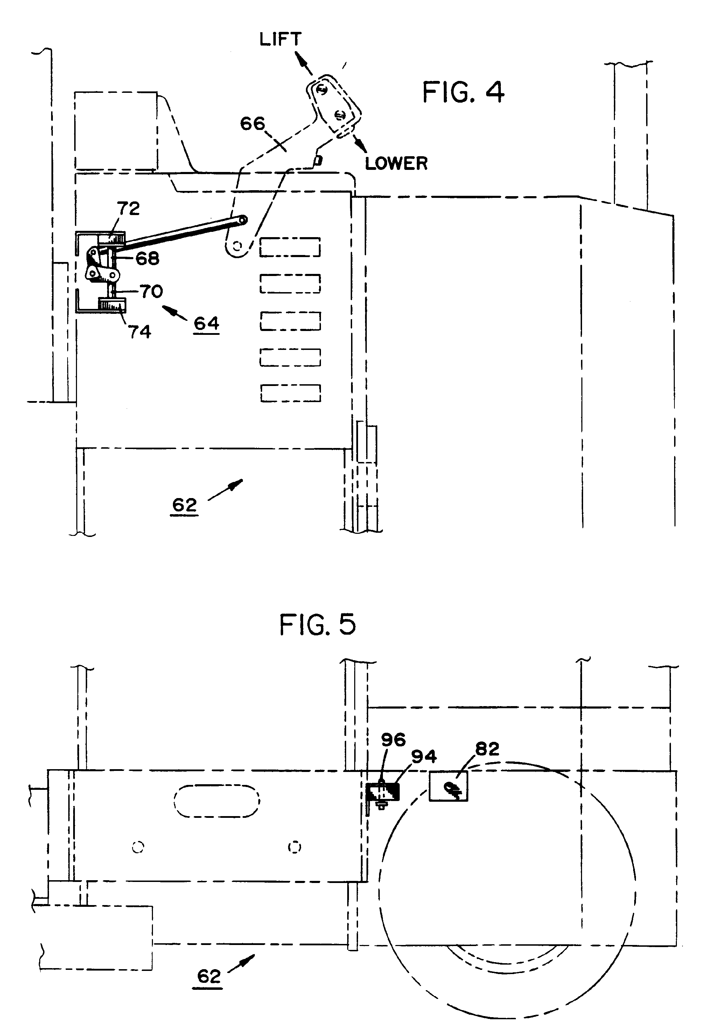

Figures 3 and 4 show the platform lift/lower switching mechanism, generally indicated by the reference numeral 64, mechanically linked to a control handle 66. Switching mechanism 64 includes actuator rods 68 and 70, with the rods disposed so that movement of control handle 66 will cause the rods to move axially in and out of inductors 72 and 74, respectively. Thus, if control handle 66 is raised, actuator rod 68 will advance into inductor 72 and actuator rod 70 will be withdrawn from inductor 74. The withdrawal of actuator rod 70 out of inductor 74 and away from its trigger point, to its iron out condition, causes the platform of the fork lift truck to rise. Lowering of control handle 66 will reverse the movement of actuator rods 68 and 70 and withdrawal of actuator rod 68 from inductor 72 and away from its trigger point, to its iron out condition, causes the platform to lower.

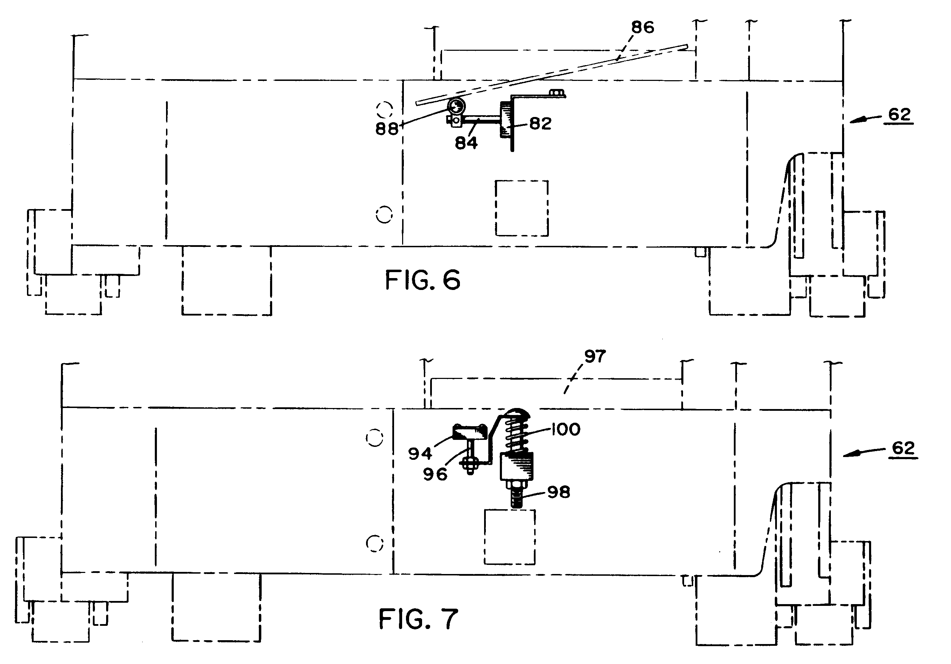

Figures 5 and 6 show the mounting of brake switch inductor 82 and its associated actuator rod 84. Actuator rod 84 is advanced or withdrawn from inductor 82 by releasing or depressing brake pedal 86 which causes shaft 88 to rotate.

Figures 5 and 7 show the mounting of platform switch inductor 94 and its associated actuator rod 96. Here, when treadle 97 of fork lift truck 62 is depressed, bolt 98 will be driven downward, compressing spring 100 and withdrawing actuator rod 96 to the trigger point of the platform switch. Likewise, releasing treadle 97 causes actuator rod 96 to be advanced into inductor 94. Figure 7 also indicates a significant advantage of the inductive switch of the present invention, that of being able to tolerate a large amount of overtravel, which most mechanical switches cannot.

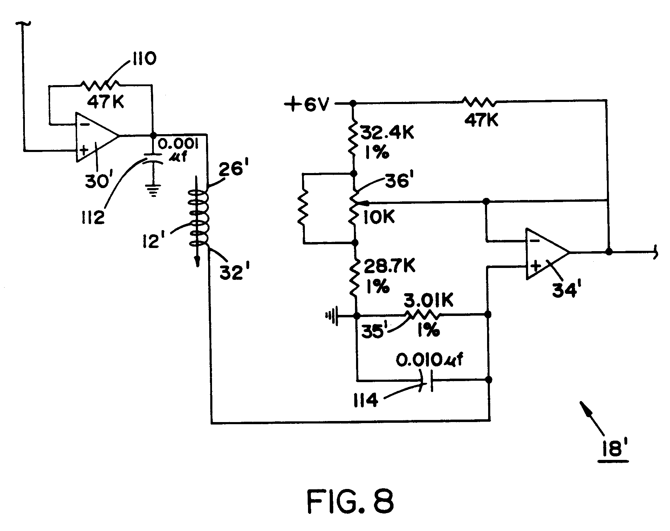

Figure 8 shows a portion of position detection circuit 18 of Figure 1A, generally indicated by the reference numeral 18′, with elements common to Figure 1A given primed reference numerals, together with its associated inductor 12′ and operational amplifier 30′. In addition to the common elements shown on Figure 1A, a resistor 110 is inserted in the feedback loop of operational amplifier 30′, a grounded capacitor 112 is connected to the output of the operational amplifier, and a capacitor 114 is connected around resistor 35′. The embodiment shown on Figure 8 is particularly advantageous when the input line to operational amplifier 30′ is relatively long and is located in an environment where electromagnetically coupled transient potentials may be developed. This is especially true in the case of electrically driven fork lift trucks where the chopper drive for the electric motor may be switching currents of 200-300 amperes. With position detection circuit 18 on Figure 1, the transient may be high enough that, depending on the devices specified, operational amplifier 30 may be driven out of its common mode range and lock up.

In position detection circuit 18′, capacitor 112 prevents the output of operational amplifier 30′ from responding too quickly, while resistor 110 limits the current that can be fed back. Likewise, capacitor 114 is provided to help discharge any effects of the transient which may pass to position detection circuit 18′. The values of resistor 110 and capacitors 112 and 114 are chosen so that these elements do not interfere with normal operation.
The electronics (not shown) associated with the inductors shown on Figures 3-8 may be located away from the inductors and may be in a completely sealed structure on fork lift truck 62, access normally being required only for purposes of calibration. With the electronics so protected, nothing in the switch system is susceptible to failure due to exposure to dirt, dust, or some degree of abuse. The inductive element itself is easily replaced by mechanics of ordinary skill.

Some considerations in the design of inductors and the measurement of inductance are discussed in "Inductance Calculations", by Frederick W. Grover, 1980, Published by the Instrument Society of America, and "Absolute Measurements in Electricity and Magnetism", by Andrew Gray, 1967, published by Dover Publications.

## Claims

1. An inductive switch comprising: inductor means (12; 13; 14; 15;); actuator means (56) movable with respect to the inductor means, the movement affecting the inductance of the inductor means; and means (28, 30) to apply an electrical pulse of a selected duration to the inductor means; and characterised in that the switch further comprises means to measure (18; 19; 20; 21; 22) the level of current directly from the inductor means a selected time interval after the initiation of the said pulse and to provide a switching signal output when the said level of current is above a predetermined value.

2. A switch according to claim 1, characterised in that the said means to measure (18; 19; 20; 21; 22) remains directly connected to the inductor means (12; 13; 14; 15) until the level of current is measured.

3. A switch according to claim 1 or claim 2, characterised in that the means to measure includes a sense resistor (35) connected to the inductor means, and circuitry (34, 38) coupled to the sense resistor (35) to compare the voltage across the sense resistor (35) at the end of the predetermined interval with a reference voltage.

4. A switch according to claim 1, characterised in that the means to measure (18; 19; 20; 21; 22) comprises:
(a) a comparator (34) having a reference voltage applied to a first input and having the output (32) of the inductor means applied to a second input; and
(b) a sense resistor (35) connected between the output (32) of said inductor means and ground;
whereby, when one of a succession of pulses causes the inductance of the inductor means to cause said level of current to exceed the said predetermined level, the output of the comparator (34) will change.

5. A switch according to claim 4, characterised by a data flip-flop (38) connected to receive as its data input the output of the said comparator (34).

6. A switch according to claim 5 characterised in that a second inductor means is connected to the means (28, 30) to apply an electrical pulse and in that the data flip-flop (38) is connected to receive as its strobe pulses the electrical pulses applied to the second inductor means such that, when one said pulse of a succession of the said pulses causes the said data input to the data flip-flop (38) to change, the next succeeding pulse of the said succession of pulses will strobe the data flip-flop (38) to change the state thereof and to so indicate on outputs therefrom.

7. A switch according to claim 5 and claim 6, characterised in that:
(a) a noninverting output of the said data flip-flop (38) is adapted to be connected to circuitry to receive a signal of the noninverting output as the output of the switch; and
(b) a feed back resistor (42) is connected between an inverting output of the data flip-flop (38) and the first input of the comparator (34).

8. A switch according to any preceding claim, characterised in that the said selected duration is on the order of from about 10 microseconds to about 1 millisecond.

9. A switch according to any preceding claim, characterised in that the said selected duration is on the order of about 130 microseconds.

10. A switch according to any preceding claim, characterised in that the inductor means comprises a coil of wire (52).

11. A switch according to claim 10 characterised in that the inductor means further comprises a concentrator (58) disposed at one end of the coil of wire so as to extend the transfer function of the inductor means.

12. A switch according to claim 11, characterised in that the outer dimension of the concentrator (58) is at least coextensive with the outer dimension on the coil (52).

13. A fork lift truck including, mounted thereon, an inductive switch as claimed in any preceding claim.

14. A fork lift truck according to claim 13 having a platform control handle (66), characterised in that the inductive switch further comprises an actuator rod (68; 70) operatively connected to the control handle, the arrangement being such that movement of the handle causes the actuator rod to advance into or withdraw from a bore defined in the inductor means (72; 74) thereby causing a change in the inductance of the inductor means (72; 74).

15. A forklift truck according to claim 13 having a brake pedal (86) characterised in that the inductive switch further comprises an actuator rod (84) operatively connected to said brake treadle (86), the arrangement being such that movement of the brake treadle causes the actuator rod to be advanced into or withdrawn from a bore defined in the inductor means (82), thereby changing the inductance of the inductor means.

16. A forklift truck according to claim 13 having a platform treadle (97), characterised in that the inductive switch further comprises an actuator rod (96) operatively connected to the platform treadle the arrangement being, such that movement of the platform treadle causes the actuator rod to advance into or withdraw from a bore defined in the inductor means (94), thereby changing the inductance of the inductor means.

17. A method of measuring the inductance of an inductor (12; 13; 14; 15) including applying an electrical pulse of a selected duration to the inductor the method being, characterised by measuring the level of current directly from the inductor a selected time interval after the initiation of the electrical pulse, said current being proportional to the value of inductance of the inductor.

18. A method according to claim 17, further characterised in that the level of current is measured by a circuit arrangement (34, 38) which is maintained directly connected to the inductor until the said level is measured.

19. A method according to claim 17, further characterised in that the level of current is measured by an arrangement including a sense resistor (35) connected to the inductor, and circuitry (34, 38) coupled to the sense resistor (35), and in that the said circuitry (34, 38) compares the voltage across the sense resistor (35) at the end of the predetermined interval with a reference voltage.

20. A method according to claim 17, characterised in that the inductance of the inductor is varied by moving an actuating element relative to the inductor, and in that a voltage output of the inductor developed across a sense resistor (35) connected between an output of the inductor and ground is applied to a first input of a comparator the second input of which receives a reference voltage, whereby when one of a succession of the said pulses causes the inductance of the inductor to cause the level of current to exceed a predetermined level, the output of the comparator will change.

21. A method according to claim 20, characterised in that the output of the comparator is received by a data flip-flop as its data input.

22. A method according to claim 21, characterised in that the pulses applied another inductor the inductance of which is to be measured are received by the data flip-flop as its strobe pulses whereby, when one said pulse of a succession of the said pulses causes the data input to the data flip-flop to change, the next succeeding pulse of the said succession of pulses will strobe the data flip-flop to change the state thereof and so to indicate on outputs therefrom.

23. A method according to claim 22, characterised in that a noninverting output of the data flip-flop is used as an inductance indicating output of an inductive switch; and in that hysteresis in the operation of the comparator is provided via a feedback resistor connected between an inverting output of the data flip-flop and the second input of the comparator.

24. A method according to any of claims 17 to 23, characterised in that the selected duration of the said pulse is on the order of from about 10 microseconds to about 1 millisecond.

25. A method according to any of claims 17 to 24, characterised in that the selected duration of the said pulse is on the order of about 130 microseconds

26. A method of operating a fork lift truck in which movement of a mechanical part activates an inductive switch in which inductance of an inductor mounted in the truck is measured by a method as claimed in any of claims 17 to 25.

27. A method according to claim 26, characterised in that movement of a platform control handle of the truck operatively connected to an actuator rod causes the actuator rod to advance into or withdraw from a bore defined in the inductor, thereby causing a change in the inductance of the inductor.

28. A method according to claim 26, characterised in that movement of a brake treadle of the truck operatively connected to an actuator rod causes the actuator rod to be advanced into or withdrawn from a bore defined in the inductor, thereby changing the inductance of the inductor.

29. A method according to claim 26, characterised in that movement of a platform treadle of the truck operatively connected to an actuator rod causes the actuator rod to advance into or withdraw from a bore defined in the inductor, thereby changing the inductance of the inductor.

## Patentansprüche

1. Induktiver Schalter enthaltend: eine Induktoreinrichtung (12; 13; 14; 15); Betätigungselemente (56), die hinsichtlich der Induktoreinrichtung bewegbar sind, wobei die Bewegung die Induktivität der Induktoreinrichtung beeinflußt; und Mittel (28, 30) zum Anlegen eines elektrischen Impulses vorgegebener Länge an die Induktoreinrichtung; und dadurch gekennzeichnet ist, daß der Schalter weiterhin Mittel (18; 19; 20; 21; 22) zum Messen des Strompegels direkt von der Induktoreinrichtung in einem vorgegebenen Zeitintervall nach der Auslösung des Impulses enthält und um einen Schaltsignalausgang zu liefern, wenn der Pegel des Stromes oberhalb eines vorgegebenen Wertes ist.

2. Schalter nach Anspruch 1, dadurch gekennzeichnet, daß die Mittel (18; 19; 20; 21; 22) zum Messen direkt mit der Induktoreinrichtung (12; 13; 14; 15) verbunden bleiben, bis der Pegel des Stromes gemessen ist.

3. Schalter nach Anspruch 1 oder 2, dadurch gekennzeichnet, daß die Mittel zum Messen einen Meßwiderstand (35), der mit der Induktoreinrichtung verbunden ist, und eine Schaltung (34, 38), die mit dem Meßwiderstand (35) verbunden ist, enthalten, um die Spannung über dem Meßwiderstand (35) zum Ende des vorgegebenen Intervalles mit einer Bezugsspannung zu vergleichen.

4. Schalter nach Anspruch 1, dadurch gekennzeichnet, daß die Mittel zum Messen (18; 19: 20; 21; 22) enthalten
a) einen Komparator (34) mit einer Bezugsspannung, die an einem ersten Eingang angelegt ist und den Ausgang (32) der Induktoreinrichtung aufweist, der mit einem zweiten Eingang verbunden ist; und
b) einen Meßwiderstand (35), der zwischen den Ausgang (32) der Induktoreinrichtung und Masse geschaltet ist;
wodurch, wenn eine Folge von Impulsen die Induktivität der Induktoreinrichtung veranlaßt, daß der Pegel des Stromes auf den vorgegebenen Pegel ansteigt, so daß sich der Ausgang des Komparators (34) ändert.

5. Schalter nach Anspruch 4, gekennzeichnet durch ein Meß-Flip-Flop (38), das angeschlossen ist, um den Ausgang des Komparators(34) als seinen Dateneingang zu empfangen.

6. Schalter nach Anspruch 5, dadurch gekennzeichnet, daß mit den Mitteln (28, 30) eine zweite Induktoreinrichtung zum Anlegen eines elektrischen Impulses verbunden ist und daß das Meß-Flip-Flop (38) angeschlossen ist, um die elektrischen Impulse, die an die zweite Induktoreinrichtung angelegt werden, als seine Triggerimpulse zu empfangen, so daß, wenn die Impulse einer Impulsfolge den Dateneingang des Meß-Flip-Flops (38) ändert, die nächsten folgenden Impulse der Impulsfolgen das Meß-Flip-Flop (38) triggert, um dessen Status zu ändern und auf diese Weise an deren Ausgängen anzuzeigen.

7. Schalter nach Anspruch 5 und 6, dadurch gekennzeichnet, daß:
a) ein nichtinvertierender Ausgang des Meß-Flip-Flops (38) zum Anschluß an die Schaltung vorgesehen ist, um ein Signal des nichtinvertierenden Ausganges als Ausgang des Schalters zu empfangen; und
b) daß ein Rückkopplungswiderstand (42) zwischen einem invertierenden Ausgang des Meß-Flip-Flops (38) und dem ersten Eingang des Komparators (34) angeschlossen ist.

8. Schalter nach einem der vorhergehenden Ansprüche, dadurch gekennzeichnet, daß die gewählte Dauer im Bereich von etwa 10 Mikrosekunden bis etwa 1 Millisekunde liegt.

9. Schalter nach einem der vorstehenden Ansprüche, dadurch gekennzeichnet, daß die gewählte Dauer im Bereich von etwa 130 Mikrosekunden liegt.

10. Schalter nach einem der vorstehenden Ansprüche, dadurch gekennzeichnet, daß die Induktoreinrichtung eine Drahtspule (52) enthält.

11. Schalter nach Anspruch 10, dadurch gekennzeichnet, daß die Induktoreinrichtung weiterhin einen Konzentrator (58) enthält, der an einem Ende der Drahtspule angeordnet ist, um die Übertragungsfunktion der Induktoreinrichtung zu erweitern.

12. Schalter nach Anspruch 11, dadurch gekennzeichnet, daß der äußere Umfang des Konzentrators (58) wenigstens mit dem äußeren Durchmesser der Spule (52) übereinstimmt.

13. Gabelstapler einschließlich eines induktiven Schalters wie in einem der vorstehenden Ansprüche beansprucht, der an diesem montiert ist.

14. Gabelstapler nach Anspruch 13, mit einem Plattform-Steuerhandgriff (66), dadurch gekennzeichnet, daß der induktive Schalter weiterhin einen Betätigungsstift (68; 70) enthält, der funktionell mit dem Steuerhandgriff gekoppelt ist, wobei die Anordnung so ist, daß eine Bewegung des Handgriffes den Betätigungsstift in oder aus einer Bohrung, die in der Spule (72, 74) definiert ist, bewegt, so daß eine Änderung der Induktivität der Spule (72; 74) bewirkt wird.

15. Gabelstapler nach Anspruch 13, mit einem Bremspedal (86), dadurch gekennzeichnet, daß der induktive Schalter weiterhin einen Betätigungsstift (84) enthält, der funktionell mit dem Bremspedal (86) verbunden ist, wobei die Anordnung so ist, daß eine Bewegung des Bremspedales den Betätigungsstift in oder aus einer Bohrung, die in der Induktoreinrichtung (82) definiert ist, bewegt, so daß die Induktivität der Induktoreinrichtung geändert wird.

16. Gabelstapler nach Anspruch 13 mit einem Plattformpedal (97), dadurch gekennzeichnet, daß der induktive Schalter weiterhin einen Betätigungsstift (96) enthält, der funktionell mit dem Plattformpedal verbunden ist, wobei die Anordnung so ist, daß eine Bewegung des Plattformpedales den Betätigungsstift in oder aus einer Bohrung, die in der Induktoreinrichtung (94) definiert ist, bewegt, so daß die Induktivität der Induktoreinrichtung geändert wird.

17. Verfahren zur Messung der Induktivität einer Spule (12; 13; 14; 15), einschließlich des Anlegens eines elektrischen Impulses einer vorgegebenen Dauer an den Induktor, wobei das Verfahren gekennzeichnet ist durch Messen des Pegels des Stromes direkt von dem Induktor in einem vorgegebenen Zeitintervall nach der Auslösung des elektrischen Impulses, wobei der Strom proportional zum wert der Induktivität des Induktors ist.

18. Verfahren nach Anspruch 17, weiterhin dadurch gekennzeichnet, daß der Pegel des Stromes durch eine Schaltungsanordnung in (34, 38) gemessen wird, die direkt mit dem Induktor verbunden ist, bis der Pegel gemessen ist.

19. Verfahren nach Anspruch 17 weiterhin dadurch gekennzeichnet, daß der Pegel des Stromes durch eine Anordnung mit einem Meßwiderstand (35) gemessen wird, der mit dem Induktor verbunden ist und einer Schaltung (34, 38), die die Spannung über dem Meßwiderstand (35) zum Ende des vorgegebenen Intervalles mit einer Bezugsspannung vergleicht.

20. Verfahren nach Anspruch 17, dadurch gekennzeichnet, daß die Induktivität des Induktors durch Bewegen eines Betätigungselementes in Bezug auf den Induktor geändert wird und daß ein Spannungsausgang des Induktors über einen Meßwiderstand (35), der zwischen einem Ausgang des Induktors und Masse geschaltet ist, an einen ersten Eingang eines Komparators angeschlossen ist, dessen zweiter Eingang eine Refferenzspannung empfängt, wodurch, wenn eine Folge der Impulse die Induktivität des Induktors beeinflußt um den Pegel des Stromes auf einen vorgegebenen Pegel anzuheben, sich der Ausgang des Komparators ändert.

21. Verfahren nach Anspruch 20, dadurch gekennzeichnet, daß der Ausgangswert des Komparators durch ein Meß-Flip-Flop als sein Dateneingangssignal erhalten wird.

22. Verfahren nach Anspruch 21, dadurch gekennzeichnet, daß die Impulse, die an einen anderen zu messenden Induktor angelegt werden, durch das Meß-Flip-Flop als seine Triggerimpulse empfangen werden, wodurch, wenn ein Impuls einer Impulsfolge den Dateneingang des Meß-Flip-Flops ändert, die nächsten angelegten Impulse der Impulsfolge das Daten-Flip-Flop triggert, um dessen Status zu ändern und so ein Ausgangssignal zu erzeugen.

23. Verfahren nach Anspruch 22, dadurch gekennzeichnet, daß ein nicht invertierender Ausgang des Meß-Flip-Flops als ein die Induktivität anzeigender Ausgang eines induktiven Schalters verwendet wird; und daß die Hysterese der Funktion des Komparators über einen Rückführungswiderstand erzeugt wird, der zwischen einem invertierenden Ausgang des Meß-Flip-Flops und dem zweiten Eingang des Komparators geschaltet ist.

24. Verfahren nach einem der Ansprüche 17 bis 23, dadurch gekennzeichnet, daß die vorgegebene Länge der Impulse im Bereich von etwa 10 Mikrosekunden bis etwa 1 Millisekunde liegt.

25. Verfahren nach einem der Ansprüche 17 bis 24, dadurch gekennzeichnet, daß die vorgegebene Dauer der Impulse im Bereich von etwa 130 Mikrosekunden liegt.

26. Verfahren zum Betreiben eines Gabelstaplers, bei dem die Bewegung eines mechanischen Teiles einen induktiven Schalter betätigt, bei dem die Induktivität eines Induktors, der im Fahrzeug montiert ist, durch ein Verfahren, das in einem der Ansprüche 17 bis 25 beansprucht ist, gemessen wird.

27. Verfahren nach Anspruch 26, dadurch gekennzeichnet, daß die Bewegung eines Plattformhandgriffes des Fahrzeuges funktionell an einen Betätigungsstift angeschlossen ist, die den Betätigungsstift zur Bewegung in oder aus einer Bohrung, die in dem Induktor definiert ist, veranlaßt, so daß eine Änderung der Induktivität des Induktors verursacht wird.

28. Verfahren nach Anspruch 26, dadurch gekennzeichnet, daß die Bewegung eines Bremspedales des Fahrzeuges funktionell an einen Betätigungsstift angeschlossen ist, was den Betätigungsstift veranlaßt, sich in oder aus einer Bohrung, die in dem Induktor definiert ist, zu bewegen, so daß die Induktivität des Induktors geändert wird.

29. Verfahren nach Anspruch 26, dadurch gekennzeichnet, daß die Bewegung eines Plattformpedales des Fahrzeuges funktionell an einen Betätigungsstift gekoppelt ist, wodurch der Betätigungsstift veranlaßt wird, sich in oder aus einer Bohrung, die in dem Induktor definiert ist, zu bewegen, so daß die Induktivität des Induktors geändert wird.

## Revendications

1. Commutateur à induction comprenant : un moyen formant inducteur (12 ; 13 ; 14 ; 15) ; un moyen formant vérin (56) mobile par rapport au moyen formant inducteur, le mouvement affectant l'inductance du moyen formant inducteur ; et un moyen (28, 30) pour appliquer une impulsion électrique d'une durée sélectionnée au moyen formant inducteur, caractérisé en ce que le commutateur comporte d'autres moyens pour mesurer (18 ; 19 ; 20 ; 21 ; 22) le niveau du courant directement à partir du moyen formant inducteur à un intervalle de temps déterminé après le début de ladite impulsion et pour fournir une sortie de signal de commutation lorsque ledit niveau de courant dépasse une valeur prédéterminée.

2. Commutateur selon la revendication 1, caractérisé en ce que ledit moyen de mesure (18 ; 19 ; 20 ; 21 ; 22) reste directement connecté au moyen formant inducteur (12 ; 13 ; 14 ; 15) jusqu'à ce que le niveau du courant soit mesuré.

3. Commutateur selon la revendication 1 ou la revendication 2, caractérisé en ce que le moyen de mesure comporte une résistance de détection (35) connectée au moyen formant inducteur, et un circuit (34, 38) couplés avec la résistance de détection (35) pour comparer la tension traversant la résistance de détection (35) à la fin de l'intervalle prédéterminé avec une tension de référence.

4. Commutateur selon la revendication 1, caractérisé en ce que le moyen de mesure (18 ; 19 ; 20 ; 21 ; 22) comprend :
(a) un comparateur (34) ayant une tension de référence appliquée à une première entrée et ayant la sortie (32) du moyen formant inducteur appliquée à une deuxième entrée ; et
(b) une résistance de détection (35) connectée entre la sortie (32) dudit moyen formant inducteur et la terre ;
par lesquels, lorsqu'une impulsion dans une succession d'impulsions a pour effet que l'inductance du moyen formant inducteur amène ledit niveau de courant à dépasser ledit niveau prédéterminé, la sortie du comparateur (34) va changer.

5. Commutateur selon la revendication 4, caractérisé en ce qu'il comporte une bascule de données (38) connectée de façon à recevoir la sortie du comparateur (34) en tant qu'entrée de données.

6. Commutateur selon la revendication 5, caractérisé en ce qu'un deuxième moyen formant inducteur est connecté aux moyens (28, 30) pour appliquer une impulsion électrique, et en ce que la bascule de données (38) est connectée de telle sorte qu'elle reçoit les impulsions électriques appliquées au deuxième moyen formant inducteur en tant que propres impulsions d'activation de telle sorte que, lorsqu'une impulsion dans une succession desdites impulsions amène ladite entrée de données dans la bascule de données (38) à changer, l'impulsion suivante de ladite succession d'impulsions aura un effet d'activation par impulsion sur la bascule de données (38) pour modifier l'état de celle-ci et être ainsi indiquée sur les sorties de celle-ci.

7. Commutateur selon les revendications 5 et 6, caractérisé en ce que :
(a) une sortie non-inversante de ladite bascule de données (38) est apte à être connectée à des éléments de circuit de façon à recevoir un signal de la sortie non inversante comme sortie du commutateur ; et
(b) une résistance de contre-réaction (42) est connectée entre une sortie inversante de la bascule de données (38) et la première entrée du comparateur (34).

8. Commutateur selon l'une quelconque des revendications précédentes, caractérisé en ce que ladite durée sélectionnée est de l'ordre de 10 microsecondes environ à 1 milliseconde environ.

9. Commutateur selon l'une quelconque des revendications précédentes, caractérisé en ce que ladite durée sélectionnée est de l'ordre de 130 microsecondes environ.

10. Commutateur selon l'une quelconque des revendications précédentes, caractérisé en ce que le moyen formant inducteur comporte un enroulement de fil métallique (52).

11. Commutateur selon la revendication 10, caractérisé en ce que le moyen formant inducteur comporte en outre un concentrateur (58) disposé à une extrémité de l'enroulement de fil métallique de façon à prolonger la fonction de transfert du moyen formant inducteur.

12. Commutateur selon la revendication 11, caractérisé en ce que la dimension extérieure du concentrateur (58) est d'étendue au moins égale à la dimension extérieure de l'enroulement (52).

13. Chariot élévateur à fourche portant, monté dessus, un commutateur à induction selon l'une quelconque des revendications précédentes.

14. Chariot élévateur à fourche selon la revendication 13 possédant une poignée de commande de la plate-forme (66), caractérisé en ce que le commutateur à induction comporte en outre une tige de vérin (68 ; 70) en liaison opérationnelle avec la poignée de commande, la disposition étant telle que le déplacement de la poignée fasse entrer la tige de vérin ou la fasse sortir d'un alésage défini dans le moyen formant inducteur (72 ; 74), provoquant ainsi un changement d'inductance du moyen formant inducteur (72 ; 74).

15. Chariot élévateur à fourche selon la revendication 13 possédant une pédale de frein (86), caractérisé en ce que le commutateur à induction comporte en outre une tige de vérin (84) en liaison opérationnelle avec ladite pédale de frein (86), la disposition étant telle que le déplacement de la pédale de frein fasse entrer la tige de vérin ou la fasse sortir d'un alésage défini dans le moyen formant inducteur (82), modifiant ainsi l'inductance du moyen formant inducteur.

16. Chariot élévateur à fourche selon la revendication 13 possédant une pédale de plate-forme (97), caractérisé en ce que le commutateur à induction comporte en outre une tige de vérin (96) en liaison opérationnelle avec ladite pédale de plate-forme, la disposition étant telle que le déplacement de la pédale de plate-forme fasse entrer la tige de vérin ou la fasse sortir d'un alésage défini dans le moyen formant inducteur (94), modifiant ainsi l'inductance du moyen formant inducteur.

17. Procédé de mesure de l'inductance d'un inducteur (12 ; 13 ; 14 ; 15) comprenant l'application d'une impulsion électrique de durée sélectionnée sur l'inducteur, le procédé étant caractérisé en ce que le niveau de courant est directement mesuré à partir de l'inducteur à un intervalle de temps sélectionné après le début de l'impulsion électrique, ledit courant étant proportionnel à la valeur d'inductance de l'inducteur.

18. Procédé selon la revendication 17, caractérisé en outre en ce que le niveau de courant est mesuré par un dispositif de circuit (34, 38) qui est tenu directement connecté à l'inducteur jusqu'à ce que ledit niveau soit mesuré.

19. Procédé selon la revendication 17, caractérisé en outre en ce que le niveau de courant est mesuré par un dispositif comportant une résistance de détection (35) connectée à l'inducteur, et un circuit (34, 38) couplé à la résistance de détection (35), et en ce que ledits éléments de circuit (34, 38) comparent la tension traversant la résistance de détection (35) à la fin de l'intervalle prédéterminé avec une tension de référence.

20. Procédé selon la revendication 17, caractérisé en ce que l'inductance de l'inducteur est modifiée en déplaçant un élément d'actionnement par rapport à l'inducteur, et en ce qu'une sortie de tension de l'inducteur développée à travers une résistance de détection (35) connectée entre une sortie de l'inducteur et la terre est appliquée à une première entrée d'un comparateur dont la seconde entrée reçoit une tension de référence, et par conséquent, lorsqu'une impulsion dans une succession d'impulsions a pour effet que l'inductance du moyen formant inducteur amène ledit niveau de courant à dépasser un niveau prédéterminé, la sortie du comparateur change.

21. Procédé selon la revendication 20, caractérisé en ce que la sortie du comparateur est reçue par une bascule de données en tant qu'entrée de données.

22. Procédé selon la revendication 21, caractérisé en ce que les impulsions appliquées à un autre inducteur dont l'inductance doit être mesurée sont reçues par la bascule de données en tant que propres impulsions d'activation avec pour effet, lorsqu'une impulsion dans une succession desdites impulsions amène ladite entrée de données dans la bascule de données à changer, l'impulsion suivante de ladite succession d'impulsions aura un effet d'activation par impulsion sur la bascule de données pour modifier l'état de celle-ci et être ainsi indiquée sur les sorties de celle-ci.

23. Procédé selon la revendication 22, caractérisé en ce qu'une une sortie non-inversante de la bascule de données sert de sortie indiquant l'inductance d'un commutateur à induction ; et en ce que l'hystérésis dans le fonctionnement du comparateur est fournie par la résistance de contre-réaction connectée entre une sortie inversante de la bascule de données et la deuxième entrée du comparateur.

24. Procédé selon l'une quelconque des revendications 17 à 23, caractérisé en ce que la durée sélectionnée de ladite impulsion est de l'ordre de 10 microsecondes environ à 1 milliseconde environ.

25. Procédé selon l'une quelconque des revendications 17 à 24, caractérisé en ce que ladite durée sélectionnée est de l'ordre de 130 microsecondes environ.

26. Procédé de manoeuvre d'un chariot élévateur à fourche dans lequel le mouvement d'une partie mécanique active un commutateur à induction dans lequel l'inductance d'un inducteur monté dans le chariot est mesurée par un procédé selon l'une quelconque des revendications 17 à 25.

27. Procédé selon la revendication 26, caractérisé en ce que le déplacement de la poignée de plate-forme du chariot en liaison opérationnelle avec une tige de vérin fait entrer la tige de vérin ou la fait sortir d'un alésage défini dans l'inducteur, provoquant ainsi un changement d'inductance de l'inducteur.

28. Procédé selon la revendication 26, caractérisé en ce que le déplacement d'une pédale de frein en liaison opérationnelle avec une tige de vérin fait entrer la tige de vérin ou la fait sortir d'un alésage défini dans l'inducteur, modifiant ainsi l'inductance de l'inducteur.

29. Procédé selon la revendication 26, caractérisé en ce que le déplacement d'une pédale de plate-forme en liaison opérationnelle avec une tige de vérin fait entrer la tige de vérin ou la fait sortir d'un alésage défini dans l'inducteur, modifiant ainsi l'inductance de l'inducteur.
